Europäisches Patentamt

European Patent Office

Office européen des brevets

(11) Numéro de publication: **0 265 336 B1**

## FASCICULE DE BREVET EUROPEEN

(45) Date de publication de fascicule du brevet: **08.04.92**   (51) Int. Cl.⁵: **G06F 7/72**

(21) Numéro de dépôt: **87402340.1**

(22) Date de dépôt: **20.10.87**

(54) **Opérateur polynomial dans les corps de Galois, et processeur de traitement de signal numérique comportant un tel opérateur.**

(30) Priorité: **22.10.86 FR 8614677**

(43) Date de publication de la demande:
**27.04.88 Bulletin 88/17**

(45) Mention de la délivrance du brevet:
**08.04.92 Bulletin 92/15**

(84) Etats contractants désignés:
**DE GB IT**

(56) Documents cités:
**EP-A- 0 165 147**
**US-A- 4 162 480**

(73) Titulaire: **THOMSON-CSF**
**51, Esplanade du Général de Gaulle**
**F-92800 Puteaux(FR)**

(72) Inventeur: **Brechard, Dominique**
**THOMSON-CSF SCPI 19, avenue de Messine**
**F-75008 Paris(FR)**
Inventeur: **Laurent, Pierre André**
**THOMSON-CSF SCPI 19, avenue de Messine**
**F-75008 Paris(FR)**

(74) Mandataire: **Turlèque, Clotilde et al**
**THOMSON-CSF SCPI**
**F-92045 PARIS LA DEFENSE CEDEX 67(FR)**

## Description

L'invention se rapporte au domaine des télécommunications numériques et plus particulièrement au traitement de signal numérique nécessaire dans ce type d'applications.

Les télécommunications numériques sont soumises à des perturbations dues, entre autres, à la faible qualité du canal de transmission ou à l'intervention de brouilleurs actifs. Elles nécessitent donc une protection efficace de l'information.

Les méthodes classiques associant une détection d'erreur simple et une procédure systématique de répétition des messages sont avantageusement remplacées par la technique des codes correcteurs d'erreurs qui introduisent une redondance dans les signaux numériques transmis et assurent un bon compromis entre le débit utile et la sécurité des données transmises. Dans l'ensemble des codes correcteurs, deux familles de codes en blocs offrent un équilibre raisonnable entre la complexité de mise en oeuvre et l'efficacité :

- les codes (BCH), construits sur un alphabet binaire, utilisés notamment pour corriger les erreurs isolées ;
- les codes REED-SOLOMON (RS), construits sur un alphabet à M symboles ayant chacun m bits, M = $2^m$, ces codes étant utilisés pour corriger des paquets d'erreurs.

Le codage et le décodage réalisé sur le signal numérique font appel à des traitements de polynômes à valeurs dans les corps de Galois.

Le brevet EP-A-0 165 147 intitulée "codeur-décodeur de codes de blocs, paramétrables", au nom de la Demanderesse, décrit un processeur spécialisé pour ce type de traitement numérique comportant un opérateur polynomial dans les corps de Galois. Cet opérateur réalise des opérations scalaires ou des opérations polynomiales sur des éléments d'un corps de Galois choisi dans les corps de Galois à 16, 32, 64, ou 128 éléments permettant de réaliser des opérations sur des symboles ayant respectivement m = 4, 5, 6 ou 7 bits. L'opérateur décrit dans cette demande ne permet pas de traiter des données dans le corps de Galois à 256 éléments, CG(256), où les calculs sont les plus complexes, mais qui permettrait le traitement d'octets qui sont les symboles de base des transmissions de données. De plus, la structure de l'opérateur décrit dans l'art antérieur précisé ci-dessus ne permet pas la réalisation d'un circuit rapide même dans les technologies actuellement les plus performantes. En outre, le déroulement des opérations nécessaires ne peut être réalisé que par des séquences d'instructions, même pour des opérations du type produit d'un polynôme par un monôme. Enfin, cet opérateur ne permet pas le masquage des données traitées, en particulier pour la localisation simple des erreurs.

L'invention a pour objet un opérateur polynomial dans les corps de Galois dont l'organisation est telle que les opérations élémentaires du type X + (Y*Z), peuvent être réalisées dans tous les corps de Galois de 16 à 256 éléments : CG(16), CG(32), CG(64), CG(128), et également CG(256) qui permet de traiter directement les octets. Cet opérateur est organisé de telle manière que l'exécution de tous les calculs polynomiaux de base dans ce type d'arithmétique, à savoir le développement d'un polynôme, le produit ou la division de polynômes, peuvent être effectués par la répétition d'une seule instruction. De plus cet opérateur peut facilement être intégré sur silicium avec une surface faible, la vitesse de calcul obtenue étant élevée. Enfin, il est également possible dans cet opérateur de réaliser un masquage des données simplement, comme il sera expliqué ci-après.

Suivant l'invention, un opérateur polynomial pour effectuer des calculs sur des données polynomiales appelées valeur Galois constituées de suites ordonnées de coefficients formés de valeurs dans les corps de Galois caractérisé en ce que les calculs sont effectués sur au plus 8 bits et un bit de validité dans un des corps de Galois de 16 à 256 éléments comportant respectivement des éléments de 4 à 8 bits significatifs et en ce l'opérateur polynomial est organisé en trois niveaux successifs :

- un premier niveau de sélection des opérandes comportant un circuit de multiplexage, à quatre entrées et trois sorties de valeurs Galois sur 8 bits, commandé par des signaux de sélection ;
- un niveau, dit de "pipe line", comportant trois registres mémoire ayant trois entrées reliées aux sorties du circuit de multiplexage, pour mettre en mémoire trois opérandes, et trois sorties associées ;
- un niveau de calcul comportant un circuit multiplieur et additionneur dans les corps de Galois qui comporte deux entrées de multiplication, reliées aux sorties de deux des registres mémoires, une entrée d'addition reliée à la sortie du troisième registre mémoire, et une sortie de résultat,

et en ce que les quatre entrées du circuit de multiplexage sont deux entrées d'opérandes pour recevoir lesdites valeurs Galois de l'extérieur de l'opérateur, une entrée reliée à la sortie de l'un des registres mémoire, et une entrée reliée à la sortie de résultat du multiplieur additionneur, la configuration du circuit de multiplexage pour relier quatre de ses entrées aux trois entrées du circuit multiplieur additionneur étant commandée par les signaux de sélection pour chaque opération polynomiale dans le corps de Galois considéré, chaque opération étant effectuée par la répétition de l'instruction de calcul X + (Y*Z) où + et * sont l'addition et la multiplication dans les corps de Galois, jusqu'à épuisement des données polynomiales ou valeurs Galois du corps considéré appliquées aux entrées d'opérandes,

L'invention a également pour objet un processeur de traitement de signal numérique comportant un tel opérateur polynomial dans les corps de Galois.

L'invention sera mieux comprise et d'autres caractéristiques apparaîtront à l'aide de la description qui suit en référence aux figures annexées.

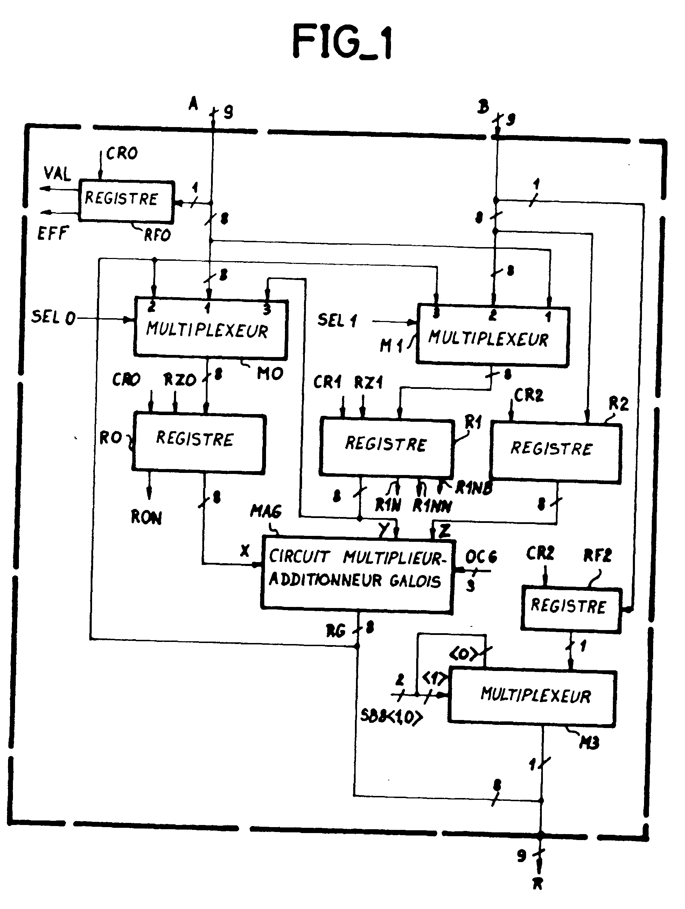

- La figure 1 représente un schéma synoptique de l'opérateur suivant l'invention ;
- La figure 2 est un schéma synoptique du circuit multiplieur-additionneur utilisé dans l'opérateur suivant l'invention ;
- La figure 3 représente le schéma de détail du circuit effectuant le calcul du produit de deux polynômes binaires ;
- La figure 4 est le schéma de détail du circuit effectuant l'addition dans l'opérateur ;
- Les figures 5, 6, 7, 8 et 9 représentent respectivement les circuits permettant de ramener les résultats des calculs polynomiaux dans le corps de Galois, respectivement CG(16), CG(32), CG(64), CG(128), CG(256) ;
- La figure 10 représente la configuration de l'opérateur Galois pour la division d'un polynôme par un monôme ;
- La figure 11 représente la configuration de l'opérateur Galois pour le développement d'un polynôme par un monôme ;
- La figure 12 représente la configuration de l'opérateur Galois pour la multiplication de deux polynômes.

D'une manière générale, l'opérateur polynomial dans les corps de Galois suivant l'invention comporte deux entrées A et B pour les opérandes et une sortie R pour le résultat, ces trois éléments ayant au plus neuf bits significatifs de rangs 0 à 8. Les données "polynomiales" sont constituées d'une suite ordonnée de coefficients ayant chacun au plus 9 bits, chaque coefficient étant composé d'une valeur dans le corps de Galois correspondant, au plus, aux huit éléments binaires de faible poids, 8LSB, et d'un bit de validité sur le bit de plus fort poids, MSB. Les circuits de traitement de ces deux types d'informations sont disjoints.

Tout d'abord le circuit de traitement des valeurs Galois qui utilise les séquences de valeurs Galois appliquées sur l'une et/ou l'autre des deux entrées d'opérandes A et B est organisé sur trois niveaux de la manière suivante :

- Un premier niveau, dit de sélection des opérandes qui comporte deux multiplexeurs, $M_0$ et $M_1$ commandés par des signaux de sélection, SEL0 et SEL1. Ces multiplexeurs M0 et M1 ont respectivement trois entrées multiples sur huit bits et une sortie sur huit bits : les multiplexeurs M0 et M1 ont une première entrée, 1, reliée à l'entrée d'opérande A ; le multiplexeur M1 a une seconde entrée 2 reliée à l'entrée d'opérande B ; la troisième entrée, 3, du multiplexeur M1 et la seconde entrée, 2, du multiplexeur M0 sont reliées à la sortie de résultat Galois RG de l'opérateur définie ci-après ; la troisième entrée, 3, du multiplexeur M0 est reliée à la sortie d'un registre R1 située au second niveau et décrit ci-après.

Dans un exemple de réalisation de l'opérateur, les signaux de sélection appliqués aux multiplexeurs peuvent être des signaux à 3 bits, l'un seulement étant actif et déterminant l'entrée du multiplexeur à relier à sa sortie.

Si le rang des bits significatifs sont notés entre crochets, la sélection de la source d'opérande via le multiplexeur M0 peut être réalisée de la façon suivante :

| Bit actif | Entrée sélectionnée = sortie M0 |
|---|---|
| SEL0 <0> | 1 : Opérande A <7 .. 0> |
| SEL0 <1> | 2 : Résultat RG <7 .. 0> |
| SEL0 <2> | 3 : Registre $R_1$ <7 .. 0> |

La sélection par le multiplexeur M1 peut être la suivante :

3

| Bit actif | Entrée sélectionnée = sortie M1 |
|-----------|--------------------------------|
| SEL1 <0> | 1 : Opérande A <7 .. 0> |
| SEL2 <1> | 2 : Opérande B <7 .. 0> |
| SEL3 <2> | 3 : Résultat RG <7 .. 0> |

- Un second niveau dit de "pipe-line", comportant trois registres de 8 bascules de type D, R0, R1, et R2, le premier registre de bascules, R0, est relié à la sortie du multiplexeur M0 ; de la même manière le second registre de bascules de type D, R1, est relié à la sortie du multiplexeur M1. Enfin, le troisième registre de bascules, R2, est relié directement à l'entrée d'opérande B. Chaque registre R0, R1, R2 comporte une entrée de commande de chargement CR0, CR1, CR2 actives sur le front montant des signaux de commande ; les registres R0 et R1 comportent par ailleurs une entrée de remise à zéro RZ0 et RZ1 également actives sur leurs fronts montants. Les registres R0 et R1 ont également des sorties d'état : une sortie R0N pour le registre R0 qui indique, lorsqu'elle est active, que le contenu de ce registre est nul, et trois sorties d'état R1N, R1NN, et R1NB pour le registre R1, qui lorsqu'elles sont actives, indiquent respectivement que le contenu du registre R1 est nul, qu'il est non nul, ou qu'il est non binaire (ni 0, ni 1 simultanément sur tous les bits). Les bits d'état correspondant sont utilisés lors de l'interprétation des résultats.

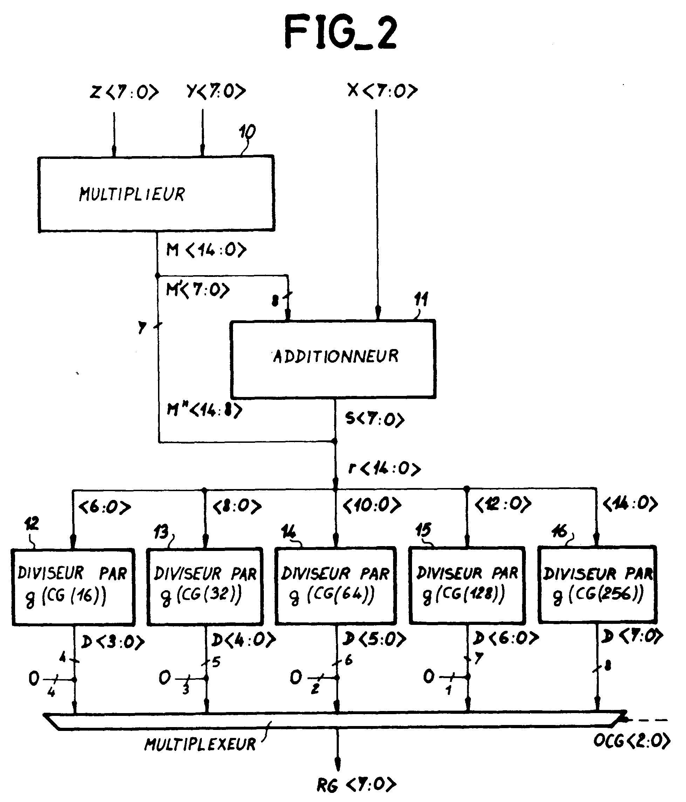

- Un troisième niveau qui est le niveau où sont effectués les calculs, additions et multiplications, nécessaires aux opérations polynomiales. Pour cela, l'opérateur comporte un circuit multiplieur-additionneur dans les corps de Galois, MAG, qui a trois entrées multiples sur 8 bits X, Y, Z respectivement reliées aux sorties des trois registres de bascules R0, R1 et R2, l'entrée X reliée au registre R0 est une entrée d'addition, tandis que les deux entrées, Y et Z, reliées aux sorties des registres de bascules R1 et R2 sont des entrées de multiplication. Un schéma détaillé de ce multiplieur-additionneur dans les corps de Galois sera donné ci-après en référence à la figure 2. La sortie multiple de ce circuit sur huit bits donne la valeur Galois RG correspondant au résultat de l'opération polynomiale dans les corps de Galois ; c'est cette sortie qui est reliée à la troisième entrée du multiplexeur M0. Le multiplieur-additionneur dans les corps de Galois réalise l'opération X + (Y * Z) = RG dans le corps de Galois considéré. Le paramètre OCG associé à l'ordre du corps de Galois 4, 5, 6, 7, ou 8, sur 3 bits, dans lequel l'opération doit être réalisée est appliqué au circuit multiplieur-additionneur MAG de façon que la configuration du multiplieur-additionneur utilisé corresponde au corps de Galois dans lequel l'opération polynomiale doit être réalisée comme il sera expliqué plus en détails ci-après en référence à la figure 2. Les trois opérandes X, Y et Z qui sont les contenus des registres R0, R1 et R2, doivent impérativement comporter un nombre de bits de faible poids significatif strictement égal à l'ordre du corps de Galois paramétré. En effet si un seul des bits de poids plus élevé de l'une des trois valeurs est non nul, le résultat obtenu est sans signification.

Dans un exemple de réalisation de l'opérateur, les valeurs Galois et les signaux de commande peuvent être les suivants :

L'ordre du corps de Galois, paramètre de 3 bits qui fixe la configuration de l'opérateur peut être :

| OCG | Corps de Galois | degré du polynôme générateur | cadrage des données dans R0, R1, R2 |
|-----|-----------------|------------------------------|-------------------------------------|
| 011 | CG(16) | 4 | 0000XXXX |
| 100 | CG(32) | 5 | 000XXXXX |
| 101 | CG(64) | 6 | 00XXXXXX |
| 110 | CG(128) | 7 | 0XXXXXXX |
| 111 | CG(256) | 8 | XXXXXXXX |

Pour le cadrage des données binaires, les signes "X" indiquent les positions des bits significatifs, les autres bits étant nécessairement nuls.

En plus des éléments décrits ci-dessus pour le traitement des valeurs Galois, l'opérateur polynomial selon l'invention comporte également une partie traitement du bit de validité. Ce circuit comporte deux registres à une bascule, RF0 et RF2, dont le chargement est commandé par les mêmes signaux CR0 et CR2 que les registres R0 et R2. Ces registres mettent en mémoire le bit de plus fort poids (rang 8) des entrées A et B. La bascule RF0 génère deux signaux d'état, EFF et VAL, respectivement actives quand RF0 est à 1 et à 0 et caractéristiques d'un effacement ou au contraire de la validité. La bascule RF2 a sa sortie reliée à la première entrée d'un multiplexeur M3, ce multiplexeur recevant également un signal de sélection à 2 bits, SB8 <1,0> pour sélectionner un bit de validité : le premier bit SB8<0> est appliqué à la seconde entrée du multiplexeur et peut prendre la valeur 0 ou 1, le second bit SB8<1> appliqué à l'entrée de commande du multiplexeur M3 permet de sélectionner l'une ou l'autre des deux entrées du multiplexeur de la façon suivante :

| SB8<1,0> | | Sortie M3 |
|---|---|---|
| SB8<1> | SB8<0> | |
| 0 | 0 | 0 |
| 0 | 1 | 1 |
| 1 | 0 ou 1 | RF2 |

Ce bit de validité affecté au résultat RG issu du multiplieur-additionneur dans les corps de Galois donne un résultat R<8 .. 0> sur neuf bits.

La figure 2 est le schéma synoptique du circuit mutiplieur-additionneur dans les corps de Galois, paramétrable par l'ordre du corps de Galois. Ce circuit comporte comme indiqué ci-dessus trois entrées multiples respectivement reliées aux sorties des registres R0, R1 et R2. Les sorties Y et Z des registres R1 et R2 sont reliées aux entrées d'un multiplieur 10 qui effectue tous les produits deux à deux des coefficients des polynômes dans les corps de Galois, soit tous les $y_i . z_j$ pour $i$ compris entre 0 et 7 et $j$ également compris entre 0 et 7. Le résultat issu de ce multiplieur est un nombre M<14 .. 0> à quinze bits significatifs 0 à 14 maximum, lorsque les valeurs traitées sont des valeurs dans le corps de Galois à 256 éléments, chacune sur huit bits. Les huit éléments de plus faible poids M'<7 ...0> sont additionnés, dans un additionneur Galois, 11, aux huit éléments binaires X<7 ... 0> à la sortie du registre R0. Le résultat issu de l'additionneur S<7 .. 0> est disponible sur huit bits qui sont les huit éléments binaires de faible poids, d'un résultat intermédiaire sur 15 bits dont les sept éléments binaires de poids plus élevés M"<14 .. 8> sont disponibles à la sortie du multiplieur. Le résultat intermédiaire r<14 ... 0> est ramené par équivalence dans le même corps de Galois que celui sélectionné. Pour cela le multiplieur-additionneur Galois paramétrable comporte cinq circuits respectivement associés aux cinq corps de Galois utiles, respectivement circuit (12) pour le corps de Galois à 16 éléments, circuit (13) pour le corps de Galois à 32 éléments, circuit (14) pour le corps de Galois à 64 éléments, circuit (15) pour le corps de Galois à 128 éléments et circuit (16) pour le corps de Galois à 256 éléments auxquels sont appliqués respectivement 7, 9, 11, 13 et 15 bits significatifs du résultat intermédiaire, suivant le corps auquel appartiennent les valeurs Galois de départ. Chacun de ces circuits effectue la division du polynôme à 15 coefficients au maximum appliqué à son entrée par le polynôme générateur du corps de Galois correspondant. Suivant l'ordre du corps de Galois, le résultat comporte un certain nombre de bits significatifs comme indiqué dans le tableau de cadrage des données indiqué ci-dessus : quatre pour le corps de Galois modulo 16, cinq pour le corps de Galois à 32 éléments, ... huit pour le corps de Galois à 256 éléments. Pour arriver à un résultat sur huit bits, les bits de plus fort poids sont positionnés à 0. Les résultats fournis par ces différents circuits 12 à 16 sont transmis aux entrées d'un multiplexeur commandé par le mot de trois bits OCG qui permet de sélectionner la sortie de l'un de ces circuits pour fournir le résultat sur huit bits.

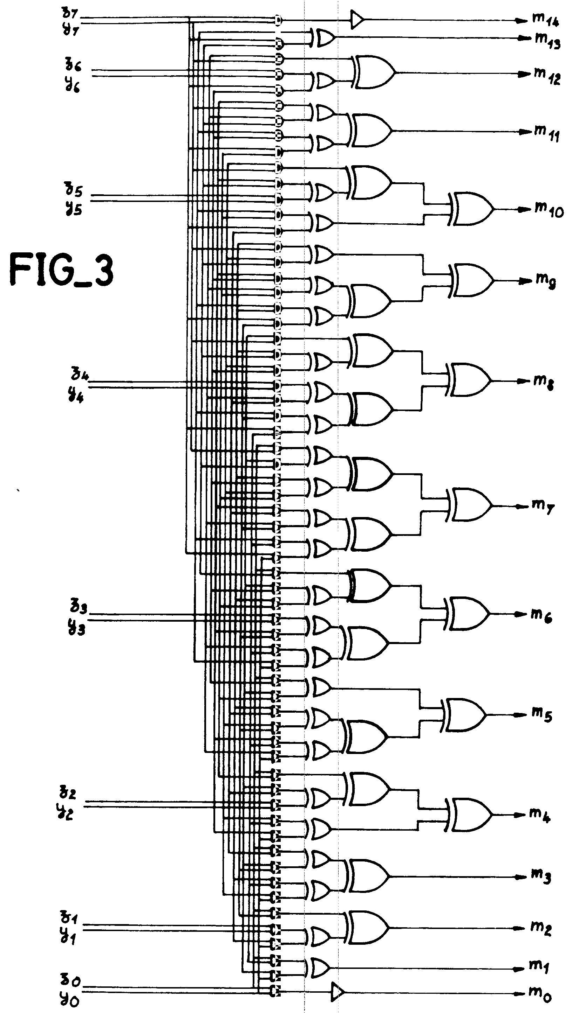

La figure 3 est un schéma de détail du multiplieur 10 de la figure 2, qui permet à partir de tous les coefficients $y_i$ de ($i$ = 0 à 7) et $z_j$ ($j$ = 0 à 7), d'effectuer les produits $y_i.z_j$ et la somme, par groupes, des termes pour lesquels $i + j$ = constante : Ainsi, le coefficient $m_0$ de M<14..0> est égal à $y_0.z_0$ , le coefficient $m_1$ est égal à $y_1.z_0 + y_0 z_1$ etc... $m_8$ est égal à $y_1 z_7 + y_2 z_6 + y_3 z_5 + y_4 z_4 + y_5 z_3 + y_6 z_2 + y_7 z_1$ ... et $m_{14} = y_7 z_7$. Comme représenté sur la figure 3, ces opérations logiques sont réalisées à partir de 64 portes ET, 2 inverseurs, et 49 portes OU exclusif, qui lors de l'intégration peuvent être réalisées sur 4 couches logiques.

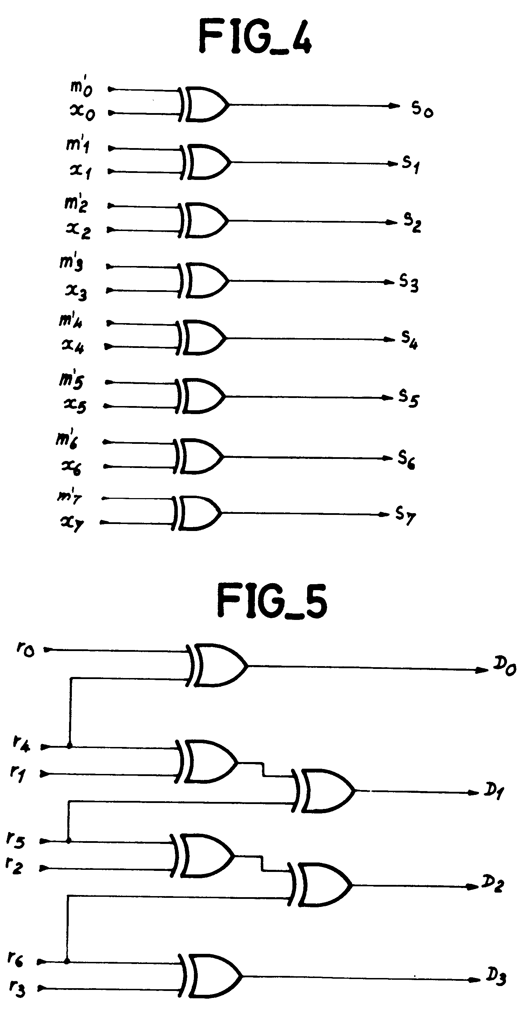

La figure 4 représente un schéma de détail de l'additionneur Galois 11 de la figure 2. Cet additionneur combine les bits de même rang sur des portes OU exclusif pour donner le résultat de sortie de l'additionneur sur le même nombre de bits soit au maximum 8, S<7..0>.

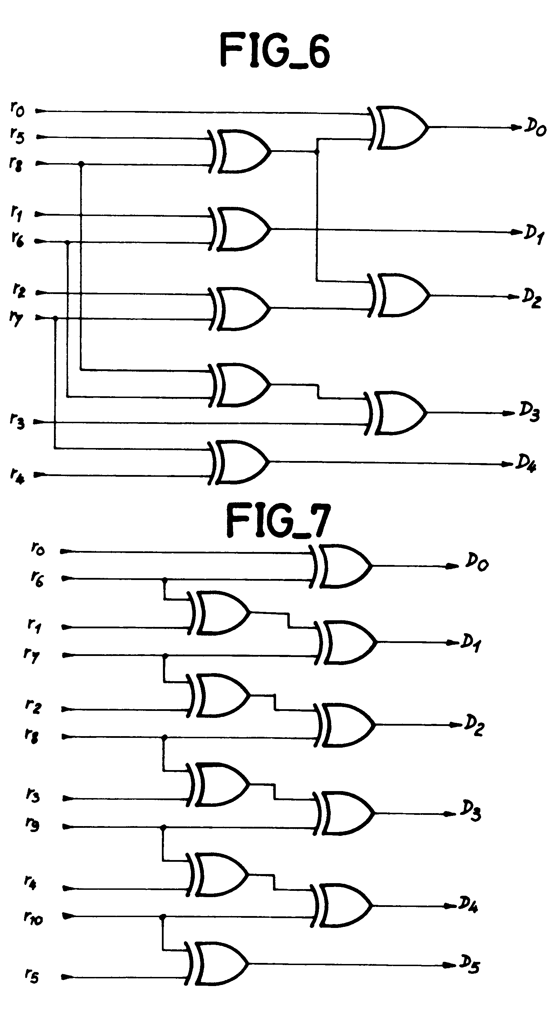

La figure 5 représente le module 12 de la figure 2 qui réalise la division du polynôme disponible à la sortie de l'additionneur par le polynôme générateur du corps de Galois à 16 éléments soit $g(CG(16)) = X^4 + X + 1$. Ce circuit est réalisé à partir de six portes OU exclusif qui combinent les bits d'entrée r<6 ... 0> de la façon suivante: $D_0 = r_0 + r_4$ ; $D_1 = r_1 + r_4 + r_5$ ; $D_2 = r_2 + r_5 + r_6$ ; $D_3 = r_3 + r_6$.

De la même manière la figure 6 représente un schéma détaillé du circuit 13 qui permet de ramener le polynôme disponible à son entrée au polynôme équivalent dans le corps de Galois à 32 éléments par division par le polynôme générateur $g(CG(32)) = X^5 + X^2 + 1$. Ce circuit est réalisé dans le mode de réalisation représenté au moyen de huit portes OU exclusif qui combinent les bits d'entrée r<8...0> de la manière suivante: $D_0 = r_0 + r_5 + r_8$ ; $D_1 = r_1 + r_6$ ; $D_2 = r_2 + r_5 + r_8$ ; $D_3 = r_3 + r_6 + r_8$ ; $D_4 = r_4 + r_7$.

De la même manière le circuit représenté sur la figure 7 est le schéma détaillé du circuit 14 de la figure 2 qui permet de ramener le polynôme à son entrée au polynôme équivalent dans le corps de Galois à 64 éléments par division par le polynôme générateur de ce corps qui est $g(CG(64)) = X^5 + X + 1$. Ce circuit est réalisé à partir de dix portes OU exclusif qui combinent les bits d'entrée r<10...0> de la manière suivante: $D_0 = r_0 + r_6$ ; $D_1 = r_1 + r_6 + r_7$ ; $D_2 = r_2 + r_7 + r_8$ ; $D_3 = r_3 + r_8 + r_9$ ; $D_4 = r_4 + r_9 + r_{10}$ ; $D_5 = r_5 + r_{10}$.

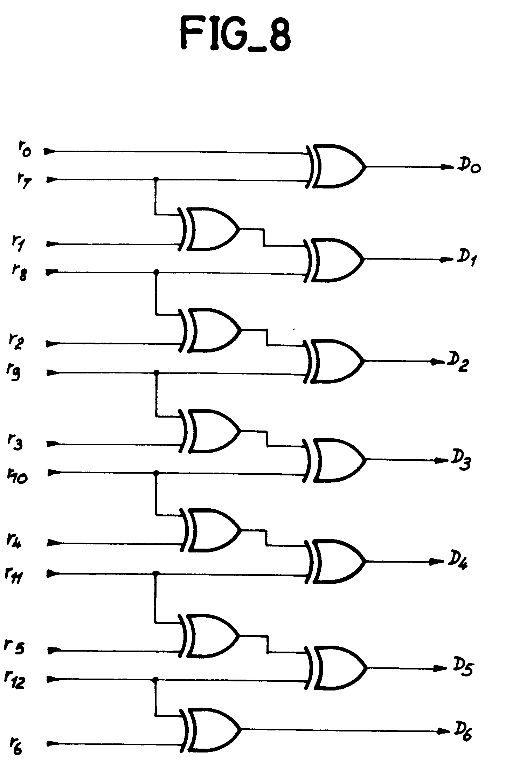

De la même manière le circuit de la figure 8 représente le circuit 15 de la figure 2 qui permet de ramener le polynôme appliqué à son entrée au polynôme équivalent dans le corps de (Galois à 128 éléments par division par le polynôme générateur $g(CG(128)) = X^7 + X + 1$. Ce circuit est réalisé au moyen de douze portes OU exclusif qui combinent les bits d'entrée r<12...0> de la manière suivante: $D_0 = r_0 + r_7$ ; $D_1 = r_1 + r_7 + r_8$ ; $D_2 = r_2 + r_8 + r_9$ ; $D_3 = r_3 + r_9 + r_{10}$ ; $D_4 = r_4 + r_{10} + r_{11}$ ; $D_5 = r_5 = r_{12} + r_{11}$ ; $D_6 = r_6 + r_{12}$.

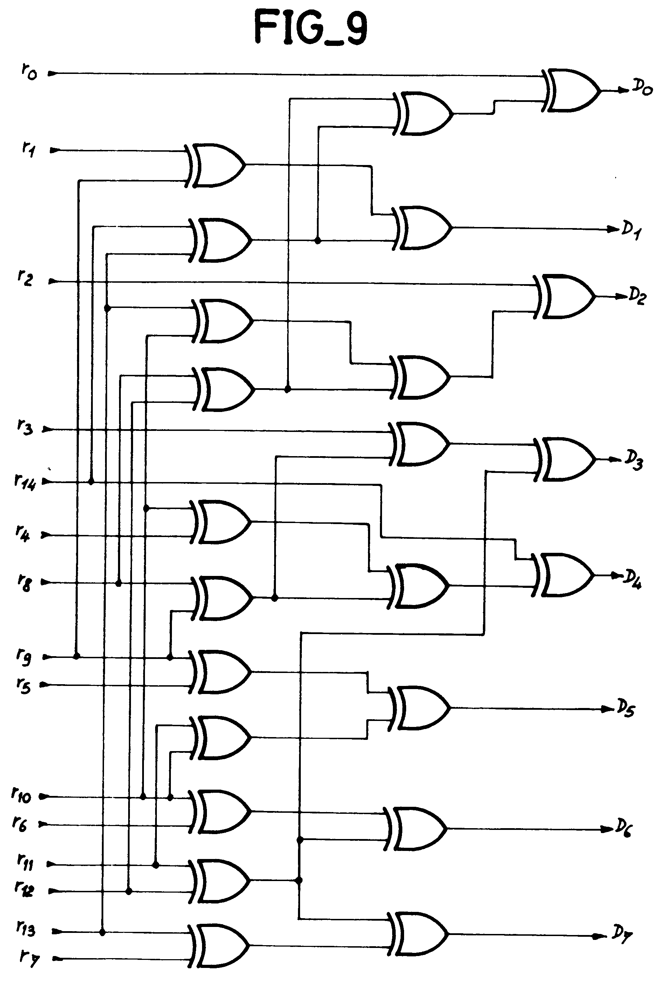

Enfin le circuit représenté sur la figure 9 est un schéma détaillé du circuit 16 de la figure 2 il permet de transformer le polynôme appliqué à son entrée dans le polynôme équivalent dans le même corps de Galois à 256 éléments par division par le polynôme générateur $g(CG(256)) = X^5 + X^4 + X^3 + X^2 + 1$. Ce circuit est réalisé au moyen de 23 portes OU exclusif qui combinent les bits d'entrée r<14 ... 0> de la manière suivante : $D_0 = r_0 + r_8 + r_{12} + r_{14}$ ; $D_1 = r_1 + r_9 + r_{13} + r_{14}$ ; $D_2 = r_2 + r_8 + r_{10} + r_{12} + r_{13}$ ; $D_3 = r_3 + r_8 + r_9 + r_{11} + r_{12}$ ; $D_4 = r_4 + r_9 + r_{10} + r_{14}$ ; $D_5 = r_5 + r_9 + r_{10} + r_{11}$ ; $D_6 = r_6 + r_{10} + r_{11} + r_{12}$ ; $D_7 = r_7 + r_{11} + r_{12}$.

Ainsi, au maximum le nombre de couches nécessaires pour la réalisation de ce circuit multiplieur-additionneur Galois paramétrable est sept couches et, au total, pour la réalisation de l'opérateur Galois sur VLSI, en tenant compte des niveaux de sélection d'entrée des opérandes et des niveaux de registres pipe-line, la réalisation de l'opérateur peut être effectuée avec une structure ayant de l'ordre de dix couches.

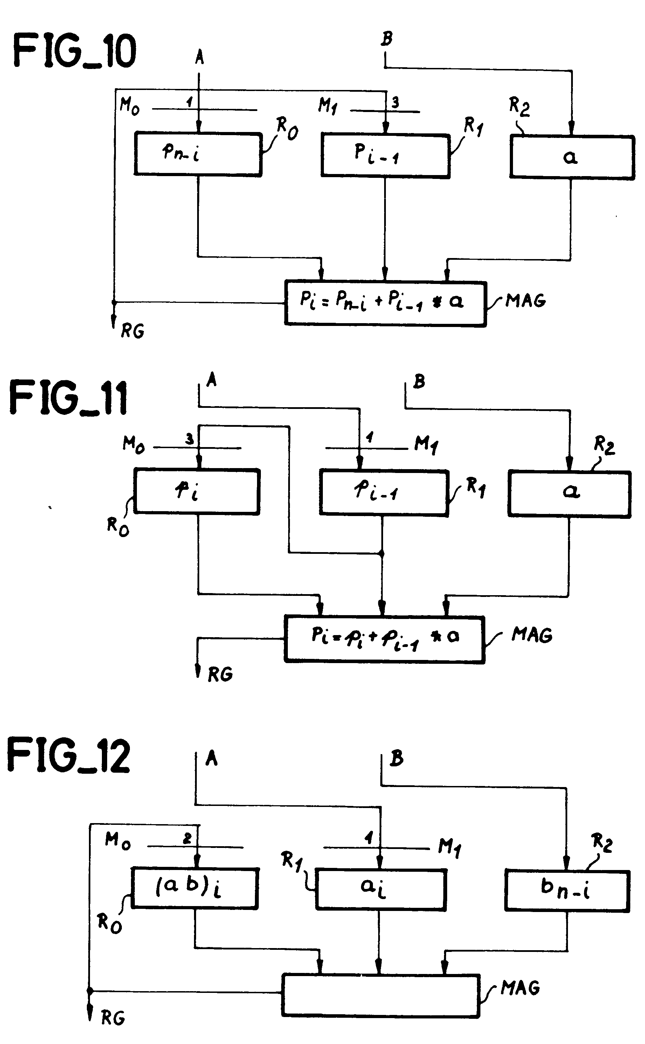

La description ci-après plus axée sur le fonctionnement du circuit précisément décrit ci-dessus, va permettre de montrer que cette structure d'opérateur permet de réaliser de manière assez simple toutes les opérations polynomiales de base pour les traitements de codage et de décodage nécessaires aux transmissions numériques: La répétition d'une seule et même instruction commandant le calcul $X + (Y \times Z)$ permet en effet de réaliser toutes les opérations polynomiales à partir d'une initialisation puis par itération. Les figures 10, 11 et 12 représentent le coeur de l'opérateur c'est-à-dire les multiplexeurs M0 et M1, les registres R0, R1, R2 et les multiplieurs-additionneurs avec seulement les connexions à travers lesquelles s'écoulent les flux de données dans trois exemples de configuration couvrant pratiquement toutes les opérations polynomiales utiles.

Sur la figure 10, l'opération polynomiale réalisée est la division d'un polynôme $P(z)$ par $(z+a)$, $(z+a)$ étant égal à $(z - a)$ dans les corps de Galois, le résultat final correspondant à la valeur du polynôme $P(z)$ au point $z = a$. Dans cette configuration le registre R1 est mis à zéro et le registre R2 est chargé, dans une phase d'initialisation, par la valeur a appliquée à l'entrée d'opérande B par activation de l'entrée de chargement CR2, puis les coefficients du polynôme $P(z)$ sont appliqués successivement, en degrés décroissants, à l'entrée A. Ils sont transmis successivement au registre R0, le multiplexeur M0 étant commandé pour que son entrée 1 soit reliée à sa sortie, et le résultat RG à chaque pas de calcul est appliqué au registre R1, le multiplexeur M1 étant commandé pour que son entrée 3 soit reliée à sa sortie. Cette opération est réalisée par itération dite de "HORNER" : si le polynôme $P(z) = p_n z^n + p_{n-1} z^{n-1} + ... p_i z^i + ... p_1 z + p_0$, dont on souhaite calculer la valeur pour $z = a$, a étant en mémoire dans le registre R2 et les coefficients $p_i$ de i égal à 0 étant appliqués successivement au registre R0, les étapes successives réalisent les opérations suivantes par répétition de la même instruction:

$$P_0 = p_n + (a \times 0) = p_n$$
$$P_1 = p_{n-1} + (a \times P_0) = p_{n-1} + ap_n$$
$$P_2 = p_{n-2} + (a \times P_1) = P_{n-2} + ap_{n-1} + a^2 p_n$$
$$.....................$$
$$P_i = p_{n-i} + (a \times P_{i-1}) = p_{n-i} + ap_{n-i} + ...a^i p_n$$
$$.....................$$
$$P_{n-1} = p_1 + (a \times P_{n-2}) = p_1 + ap_2 + ... ap_i + ... a^{n-1} p_n$$
$$P_n = p_0 + (a \times P_{n-1}) = p_0 + ap_1 + a^2 p_2 + ... a^i p_i + ... + a^n p_n$$

Les résultats intermédiaires $p_i$ sont les coefficients du polynôme quot ient de la divison de P(z) par (z + a). En effet, calculer la valeur d'un polynôme en un point (z = a) revient à calculer le reste de la division par le monôme qui a pour racine le point a en question. Dans les procédés de décodage, le calcul du reste final $\overline{P_n}$ peut permettre de calculer un syndrome s'il y a présence d'erreur dans un mot de code reçu.

Dans la configuration représentée sur la figure 11, l'opérateur Galois permet de réaliser le développement d'un polynôme H(z) par le monôme (1 + az). Comme dans le cas précédent le registre R2 est chargé initialement par la valeur a et le registre R1 est mis à zéro, l'état initial du registre R0 étant quelconque. Les coefficients du polynôme P(z) sont appliqués suivant les degrés croissants à l'une ou l'autre des entrées A et B, ces coefficients étant introduits successivement dans le registre R1 soit via l'entrée 1 du multiplexeur M1 (comme représenté sur la figure 11) soit via l'entrée 2 de ce même multiplexeur. Le registre R0 est chargé via l'entrée 3 du multiplexeur M0 par le contenu du registre R1, c'est-à-dire qu'à un instant donné le registre R0 comporte le coefficient $p_{i-1}$ et le registre R1 le coefficient $p_i$ et le registre R2 la valeur a. Le résultat issu du multiplieur-additionneur donne les coefficients $P_i$ du polynôme P(z)(1 + az) en succession dans l'ordre croissant.

Pour un développement du polynôme P(z) par (a + z), la même configuration est utilisée mais les coefficients de P(z) sont entrés en A ou en B non plus en degrés croissants mais en degrés décroissants (et avec une constante de proportionnalité).

La configuration de l'opérateur Galois représentée sur la figure 12 permet de calculer les coefficients du produit de deux polynômes $A(z) = a_o + a_1 z + a_2 z^2 + ... a_i z^i + ... + a_n z^n$ et $B(z) = b_o + b_1 z + b_2 z^2 + ... b_i z^i + ... b_n z^n$ dont les coefficients sont appliqués respectivement aux entrée A et B. Les coefficients de B(z) sont appliqués successivement au registre R2. Les coefficients du polynôme A(z) sont appliqués au registre R1 via l'entrée 1 du multiplexeur M1, et la sortie de résultat du multiplieur additionneur est reliée au registre R0, via l'entrée 2 du multiplexeur M0. Le multiplieur calcule des produits $a_i \times b_j$ ; les coefficients $a_i$ et $b_j$ sont présentés sur les entrées A et B, et les remises à zéro des registres sont commandées de telles manière que les coefficients $a_i$ et $b_j$ pour i et j variables tels que i + j = constante sont accumulés, le coefficient de degré i+j étant pris en considération lorsque tous les produits possibles tels que i = j = constante sont épuisés.

Les coefficients des polynômes A(z) et B(z) nécessaires au calcul d'un coefficient de degré différent du produit sont alors à nouveau présentés sur les entrées d'opérandes.

La succession des étapes peut être la suivante :

$a_o \times b_o = (ab)_o$

remise à zéro du registre R0.

$O + (a_o{}^*b_1)$
$|a_o{}^* b_1| + (a_1{}^*b_o) = (ab)_1$

remise à zéro du registre R0.

$O + (a_o{}^*b_2)$
$|a_o{}^*b_2| + (a_2{}^*b_o)$
$|(a_o{}^*b_2) + (a_1{}^*b_1)| + (a_2{}^*b_o)$
$|(a_o{}^*b_2) + (a_1{}^*b_1) + (a_2{}^*b_o)| = (ab)_2$

remise à zéro du registre R0 ... etc ...

Comme indiqué ci-dessus, c'est toujours la même instruction (X + (Y $\times$ Z)) qui est utilisée pour le calcul, et la suite des résultats intermédiaires donne la suite des coefficients du polynôme produit.

Ces différentes opérations polynomiales sont celles couramment utilisées dans les algorithmes de codage et de décodage des codes correcteurs d'erreurs de type BCH ou REED SOLOMON.

Par exemple, comme indiqué ci-dessus l'opération polynomiale P(z)/(z + a) permet de calculer chaque syndrome lors du décodage, pour la détection d'erreurs. Cette opération est également utilisée dans un algorithme de codage du type Reed Solomon.

L'opération P(z) (1 + az) peut être également utilisée dans les algorithmes de codage Reed Solomon pour calculer le polynôme inverse du polynôme générateur du code. Elle peut également être utilisée lors du décodage d'un mot de code comportant des informations d'effacement pour créer le polynôme localisateur d'effacement associé à ce mot.

Le produit de deux polynômes peut être utilisé lors du codage pour calculer les bits de redondance à

7

rajouter aux bits formant l'information, par convolution du mot d'information et du polynôme générateur inverse du code.

Pratiquement, toutes les opérations mises en oeuvre dans les algorithmes de codage et de décodage peuvent être réalisées par l'opérateur décrit ci-dessus, et par la répétition d'une seule et même instruction de calcul.

Les figures 3 à 9 représentent un mode de réalisation susceptible d'être modifié. Ce mode particulier permet cependant la réalisation de l'opérateur dans un circuit en silicium VLSI à 9 ou 10 couches actives, c'est-à-dire en réalisant un bon compromis entre vitesse et complexité.

## Revendications

**1.** Opérateur polynomial, pour effectuer des calculs sur des données polynomiales appelées valeurs Galois constituées de suites ordonnées de coefficients formés de valeurs dans les corps de Galois caractérisé en ce que les calculs sont effectués sur au plus 8 bits et un bit de validité dans un des corps de Galois de 16 à 256 éléments comportant respectivement des éléments de 4 à 8 bits significatifs, et en ce que l'opérateur polynomial est organisé en trois niveaux successifs :
- un premier niveau de sélection des opérandes comportant un circuit de multiplexage (MO, M1), à quatre entrées et trois sorties de valeurs Galois sur 8 bits, commandé par des signaux de sélection (SEL0, SEL1) ;
- un niveau, dit de "pipe line", comportant trois registres mémoire (RO, R1, R2) ayant trois entrées reliées aux sorties du circuit de multiplexage, pour mettre en mémoire trois opérandes, et trois sorties associées (X, Y, Z) ;
- un niveau de calcul comportant un circuit multiplieur et additionneur dans les corps de Galois (MAG) qui comporte deux entrées de multiplication (Y et Z), reliées aux sorties de deux des registres mémoires (R1 et R2), une entrée d'addition (X) reliée à la sortie du troisième registre mémoire (R0), et une sortie de résultat (RG),

et en ce que les quatre entrées du circuit de multiplexage (M0, M1) sont deux entrées d'opérandes (A, B) pour recevoir lesdites valeurs Galois de l'extérieur de l'opérateur, au moins une entrée reliée à la sortie de l'un des registres mémoire (Y), et une entrée reliée à la sortie de résultat (RG) du multiplieur additionneur, la configuration du circuit de multiplexage (M0, M1) pour relier quatre de ses entrées aux trois entrées (X, Y, Z) du circuit multiplieur additionneur étant commandée par les signaux de sélection (SEL0, SEL1) pour chaque opération polynomiale dans le corps de Galois considéré, chaque opération étant effectuée par la répétition de l'instruction de calcul X + (Y*Z) où + et * sont l'addition et la multiplication dans les corps de Galois, jusqu'à épuisement des données polynomiales ou valeurs Galois du corps considéré appliquées aux entrées d'opérandes (A, B).

**2.** Opérateur selon la revendication 1, caractérisé en ce que le circuit de multiplexage comporte deux multiplexeurs à trois entrées (M0, M1), le niveau de "pipe" line" étant tel qu'un premier registre (R2) est toujours alimenté par la même entrée d'opérande (B), un deuxième registre (R1) est alimenté par l'une ou l'autre des entrées d'opérandes ou par la sortie de résultat (RG) via le multiplexeur (M1), le troisième registre (R0) étant alimenté soit par une entrée d'opérande (A), soit par la sortie de résultat (RG) ou soit par la sortie du deuxième registre (R1) via un des deux multiplexeurs à trois sorties (M0).

**3.** Opérateur selon l'une des revendications 1 et 2, caractérisé en ce que, pour le traitement du bit de validité des coefficients des polynômes, l'opérateur comporte en outre un circuit de traitement des bits de validité ayant des mémoires à un bit (RF0, RF2) associées à chacun des bits de validité des opérandes d'entrée, des entrées de commande (CR0, CR2) et une sortie fournissant le bit de validité à affecter au résultat (RG) du multiplieur additionneur pour former le résultat (R) disponible à la sortie de l'opérateur.

**4.** Opérateur selon l'une des revendications 1 à 3, caractérisé en ce que, traitant des valeurs Galois dans l'un des cinq corps Galois considéré à 16, 32, 64, 128 ou 256 éléments comportant respectivement des éléments à 4, 5, 6, 7 ou 8 bits significatifs, le circuit multiplieur additionneur (MAG) comporte cinq circuits (12, 13, 14, 15, 16) de division du résultat RG de l'opération X + (Y * Z), obtenu au plus sur 15 bits, respectivement par les polynômes générateurs de ces corps pour ramener les résultats aux valeurs Galois équivalentes ayant au plus 8 bits.

**5.** Opérateur selon l'une des revendications 1 à 4, caractérisé en ce qu'il est réalisé sous forme intégrée dans une technologie VLSI, la structure résultante ayant de l'ordre de 10 couches actives.

6. Application de l'opérateur selon l'une des revendications précédentes dans un processeur de traitement de signal numérique paramétrable, réalisant le codage et/ou le décodage des codes détecteurs correcteurs d'erreurs BCH et Reed Solomon.

**Claims**

1. A polynomial operator for performing polynomial calculations on data, termed Galois values, constituted by ordered sequences of coefficients formed by values in the Galois body, characterized in that the calculations are performed on at the most 8 bits and one validity bit in a Galois body of 16 to 256 elements, comprising respectively elements of 4 to 8 significant bits organized in three successive levels:
   - a first operand selection level comprising a multiplexing circuit (M0 and M1), with four inputs and three outputs for 8 bit Galois values, controlled by select signals (SEL0 and SEL1),
   - a pipeline level comprising three memory registers (R0, R1 and R2) having three inputs connected with the outputs of the multiplexing circuit in order to store three operands in the memory, and three associated outputs (X, Y and Z),
   - a calculation level comprising an adder-multiplier circuit in the Galois body (MAG), which comprises two multiplication inputs (Y and Z) connected with the inputs of two of the memory registers (R1 and R2), an addition input (X) connected with the output of the third memory register (R0) and a result output (RG),
   - and in that the four inputs of the multiplexing circuit (M0 and M1) are two operand inputs (A and B) in order to receive the said Galois values from the exterior of the operator, at least one input connected with the output of the one of the memory registers (Y), and an input connected with the result output (RG) of the adder-multiplier, the configuration of the multiplexing circuit (M0 and M1) for connecting four of its inputs with the three inputs (X, Y and Z) of the adder-multiplier circuit being controlled by the select signals (SEL0 and SEL1) for each polynomial operation in the Galois body considered, each operation being performed by the repetition of the calculation instruction X + (Y * Z), wherein + and * are the addition and the multiplication in the Galois bodies, until exhaustion of the polynomial data of Galois values of the body considered applied to the operand inputs (A and B).

2. The operator as claimed in claim 1, characterized in that the multiplexing circuit comprises two multiplexers with three inputs (M0 and M1), the pipeline level being such that a first register (R2) is always supplied by the same operand input (B), a second register is supplied by one or the other of the operand inputs or by the result output (RG) via the multiplexer (M1), the third register (R0) being supplied either by an operand input (A), by the result output (RG) or by the output of the second register (R1) via one of the multiplexers (M0) which have three outputs (M0).

3. The operator as claimed in claim 1 or in claim 2, characterized in that in order to treat the validity bit of the polynomial coefficients the operator furthermore comprises a validity bit treatment circuit having single bit memories (RF0 and RF2) associated with each of the validity bits of the input operands, control inputs (CR0 and CR2) and an output supplying the validity bit for the result (RG) of the adder-multiplier in order to form the result (R) available at the output of the operator.

4. The operator as claimed in claim 1 or in claim 3, characterized in that, treating Galois values in one of the five Galois bodies considered with 16, 3 2, 64, 128 or 256 elements comprising respectively elements with 4, 5, 6, 7 or 8 significant bits, the adder-multiplier circuit (MAG) comprises five circuits (12, 13, 14, 15 and 16) for the division of the result (RG) of the operation X + (Y * Z) obtained in excess of 15 bits respectively by the polynomials generating these bodies in order to restore the results to the equivalent Galois values having at least 8 bits.

5. The operator as claimed in any one of the preceding claims 1 through 4, characterized in that it is made in an integrated form using VLSI technology, the resulting structure having of the order of 10 active layers.

6. The application of the operator as claimed in any one of the preceding claims in a processor for the treatment of a digital parametrable signal performing encoding and/or decoding of the BCH and Reed Solomon error corrector detector codes.

**Patentansprüche**

1. Polynomoperator zum Ausführen von Rechnungen an polynomialen Daten, genannt Galois-Werte, die aus geordneten Folgen von aus Werten der Galois-Körper gebildeten Koeffizienten aufgebaut sind, dadurch gekennzeichnet, daß die Rechnungen an höchstens 8 Bits und einem Validitätsbit in einem der Galois-Körper von 16 bis 256 Elementen, die jeweils 4 bis 8 signifikante Bits aufweisen, ausgeführt werden und daß der Operator in drei aufeinanderfolgenden Ebenen organisiert ist:
   - einer ersten Ebene für die Wahl von Operanden, mit einer Multiplex-Schaltung (M0, M1) mit vier Eingängen und drei Ausgängen für Galois-Werte von 8 Bits, die von Wählsignalen (SEL0, SEL1) gesteuert wird;
   - einer Ebene, genannt "Pipeline", mit drei Speicherregistern (R0, R1, R2) mit drei mit den Ausgängen der Multiplex-Schaltung verbundenen Eingängen, um drei Operanden im Speicher abzulegen, und drei zugeordneten Ausgängen (X, Y, Z);
   - einer Rechenebene, mit einer Schaltung für Multiplikationen und Additionen in den Galois-Körpern (MAG), die zwei mit den Ausgängen von zwei der Speicherregister (R1 und R2) verbundene Multiplikationseingänge (Y und Z), einen mit dem Ausgang des dritten Speicherregisters (R0) verbundenen Additionseingang (X) und einen Ergebnisausgang (RG) umfaßt,
   und daß die vier Eingänge der Multiplex-Schaltung (M0, M1) zwei Operandeneingänge (A, B) für den Empfang der Galois-Werte von außerhalb des Operators, wenigstens einen mit dem Ausgang eines der Speicherregister (Y) verbundenen Eingang und einen mit dem Ergebnisausgang (RG) des Multiplizierers/Addierers verbundenen Eingang darstellen, wobei die Konfigurationen der Multiplex-Schaltung (M0, M1) zum Verbinden von vier ihrer Eingänge mit drei Eingängen (X, Y, Z) der Multiplikations-/Additionsschaltung durch Wählsignale (SEL0), SEL1) für jede Polynomoperation im betrachteten Galois-Körper gesteuert wird, wobei jede Operation, bis zum Aufbrauch der in die Operandeneingänge (A, B) eingegebenen polynomialen Daten oder Galois-Werte des betrachteten Körpers, durch die Wiederholung des Rechenbefehls $X + (Y^*Z)$ ausgeführt wird, wobei + und * die Addition bzw. die Multiplikation in den Galois-Körpern bedeuten.

2. Operator gemäß Anspruch 1, dadurch gekennzeichnet, daß die Multiplex-Schaltung zwei Multiplexer mit drei Eingängen (M0, M1) umfaßt, wobei die "Pipeline"-Ebene derart beschaffen ist, daß ein erstes Register (R2) stets durch den gleichen Operandeneingang (B) versorgt wird, ein zweites Register (R1) durch den einen oder den anderen der Operandeneingänge oder über den Multiplexer (M1) durch den Ergebnisausgang (RG) versorgt wird und das dritte Register (R0) entweder durch einen Operandeneingang (A) oder durch den Ergebnisausgang (RG) oder über einen der zwei Multiplexer mit drei Ausgängen (M0) durch den Ausgang des zweiten Registers (R1) versorgt wird.

3. Operator gemäß einem der Ansprüche 1 und 2, dadurch gekennzeichnet, daß der Operator für die Verarbeitung des Validitätsbits der Polynomkoeffizienten außerdem eine Schaltung für die Verarbeitung der Validitätsbits umfaßt, die 1-Bit-Speicher (RF0, RF2), die jedem der Validitätsbits der Eingangsoperanden zugeordnet sind, Steuereingänge (CR0, CR2) und einen das Validitätsbit liefernden Ausgang aufweist, um das Ergebnis (RG) des Multiplizierers/Addierers zu beeinflussen, um das am Ausgang des Operators verfügbare Ergebnis (R) zu bilden.

4. Operator gemäß einem der Ansprüche 1 bis 3, dadurch gekennzeichnet, daß die Multiplikations-/Additionsschaltung (MAG) bei der Verarbeitung von Galois-Werten in einem der fünf betrachteten Galois-Körper mit 16, 32, 64, 128 oder 256 Elementen, die entsprechend Elemente mit 4, 5, 6, 7 oder 8 signifikanten Bits enthalten, fünf Schaltungen (12, 13, 14, 15, 16) für die Division des durch die jeweiligen erzeugenden Polynome dieser Körper für höchstens 15 Bits erhaltenen Ergebnisses RG der Operation $X + (Y^*Z)$ umfaßt, um die Ergebnisse auf äquivalente Galois-Werte mit höchstens 8 Bits zurückzuführen.

5. Operator gemäß einem der Ansprüche 1 bis 4, dadurch gekennzeichnet, daß er in integrierter Form in VLSI-Technologie verwirklicht wird, wobei die Anzahl der aktiven Schichten der sich ergebenden Struktur in der Größenordnung von 10 liegt.

**6.** Anwendung des Operators gemäß einem der vorangehenden Ansprüche in einen Prozessor für die Verarbeitung von parametrierbaren digitalen Signalen, der die Kodierung und/oder die Dekodierung von BCH- und Reed-Solomon- Fehlererfassungs- und -Fehlerkorrekturkodes verwirklicht.

# FIG_1

# FIG_2

# FIG_3

# FIG_4

# FIG_5

# FIG_6

# FIG_7

# FIG_8

# FIG_9

## FIG_10

$P_i = P_{n-i} + P_{i-1} * a$

## FIG_11

$P_i = P_i + P_{i-1} * a$

## FIG_12